# EUROPÄISCHE PATENTSCHRIFT

(11) **EP 3 146 478 B1**
(45) Veröffentlichungstag und Bekanntmachung des Hinweises auf die Patenterteilung: **19.10.2022**
(21) Anmeldenummer: 15718775.8
(22) Anmeldetag: 21.04.2015
(51) Int. Cl.: G06K 19/077

(54) **VERFAHREN ZUR HERSTELLUNG EINER FOLIE, DIE ALS TRÄGER FÜR ELEKTRONISCHE BAUELEMENTE DIENT**
METHOD FOR PRODUCING A FILM WHICH SERVES AS A CARRIER FOR ELECTRONIC COMPONENTS
DISPOSITIF DE FABRICATION D'UN FILM, QUI SERT DE SUPPORT POUR DES COMPOSANTS ÉLECTRONIQUES

(30) Priorität: 21.05.2014 DE 102014007474
(43) Veröffentlichungstag der Anmeldung: 29.03.2017
(73) Patentinhaber: Giesecke+Devrient Mobile Security GmbH, 81677 München (DE)
(72) Erfinder: TARANTINO, Thomas, 83410 Laufen (DE); GRIESMEIER, Robert, 83052 Bruckmühl (DE)
(74) Vertreter: Giesecke + Devrient IP
(86) Internationale Anmeldenummer: PCT/EP2015/000835
(87) Internationale Veröffentlichungsnummer: WO 2015/176792

(56) Entgegenhaltungen:
- WO-A1-2011/059151
- WO-A1-2013/158090
- US-A1- 2007 296 592

## Beschreibung

Die Erfindung beschreibt ein Verfahren zur Herstellung eines tragbaren Datenträgers, wobei der tragbare Datenträger eine Folie enthält die als Träger für elektronische Bauelemente dient.

WO 2013/158090 A1 zeigt einen Transponder mit einem transparenten leitenden Material, welches ein Bauelement mit einer Antenne verbindet.

Aus dem Stand der Technik ist die Herstellung von tragbaren Datenträgern bekannt. Die tragbaren Datenträger bestehen z.B. aus mehreren Folienschichten, die durch ein Laminationsverfahren mittels Druck und Wärme dauerhaft miteinander verbunden werden. Elektronische Bauelemente, wie z.B. eine Antenne, werden beispielsweise auf eine Folienschicht aufgebracht bevor sie mit den anderen Folienschichten laminiert wird. Chips werden beispielsweise in Modulform in einen Datenträger integriert, indem das Modul in eine Ausnehmung des Datenträgers eingesetzt und gegebenenfalls mit einer Antenne verbunden wird. Auf einer Aussenseite des Moduls befindet sich gewöhnlich eine kontaktgebundene Schnittstelle, z.B. gemäß ISO 7816.

Ferner sind aus dem Stand der Technik flexible Leiterplatten bekannt, in die elektronische Bauelemente integriert sind. Die flexiblen Leiterplatten sind aus verschiedenen Schichten aufgebaut, wobei in jeder Schicht unterschiedliche elektronische Bauelemente angeordnet sind. Zwischen den Schichten bestehen elektrisch leitende Verbindungen, um die Bauelemente der verschiedenen Schichten zu einer geeigneten Schaltung zu verbinden.

Nachteilig am Stand der Technik ist, dass die Integration von elektronischen Bauelementen, wie z.B. Chips, Displays, Sensoren, etc. sehr aufwändig ist, da die Bauelemente aufgrund ihrer unterschiedlichen Bauhöhe in Aussparungen eingesetzt werden müssen, wobei die jeweiligen Aussparungen unterschiedlich viele Folienschichten durchdringen. Falls ein Modul in den Datenträger integriert werden soll, dann muss eine entsprechende Ausnehmung im Datenträger hergestellt werden. Die Herstellung insbesondere von Ausnehmungen ist vergleichsweise teuer und zeitaufwändig.

Ausgehend vom Stand der Technik ist es Aufgabe der Erfindung eine Lösung zu finden, welche die beschriebenen Nachteile vermeidet.

Die Aufgabe der Erfindung wird durch den unabhängigen und den nebengeordneten Anspruch gelöst. Vorteilhafte Ausführungen sind in den abhängigen Ansprüchen beschrieben.

Zur Lösung der Aufgabe offenbart die Erfindung ein Verfahren zur Herstellung eines tragbaren Datenträgers gemäß Anspruch 1.

Durch die getrennte Herstellung der Folie als Träger mindestens eines elektronischen Bauelements, eines sogenannten funktionalen Overlays, kann diese einfach in einen Datenträger integriert werden bzw. auf diesen aufgebracht werden, ohne, dass man sich um Ausnehmungen für elektronische Bauelemente kümmern muss. Darüber hinaus werden Kosten gesenkt, da teure Trägerbänder für z.B. ein Chipmodul nicht mehr notwendig sind.

Vorteilhafte Ausführungsbeispielen sind in den abhängigen Ansprüchen 2-12 beschrieben.

Im Folgenden wird ein Ausführungsbeispiel der Erfindung anhand der beigefügten Figuren beschrieben.
Figur 1 zeigt ein erstes Ausführungsbeispiel eines Querschnitts einer erfindungsgemäßen Folie, in der ein Chip mit Kontaktflächen gemäß ISO 7816, einer Antennenspule und einer Durchkontaktierung dargestellt ist.
Figur 2 zeigt ein zweites Ausführungsbeispiel eines Querschnitts einer erfindungsgemäßen Folie, in der eine Abdeckung auf der gegenüberliegenden Folienseite des Chips angeordnet ist, damit der Chip nicht von aussen zu erkennen ist.
Figur 3 zeigt ein drittes Ausführungsbeispiel eines Querschnitts einer erfindungsgemäßen Folie, bei der zusätzlich zum zweiten Ausführungsbeispiel ein zusätzliches elektronisches Bauelement, z.B. eine Anzeige oder ein Sensor, auf der Folie angeordnet ist.
Figur 4 zeigt einen Querschnitt des prinzipiellen Aufbaus eines erfindungsgemäßen tragbaren Datenträgers, in den eine erfindungsgemäße Folie integriert ist.

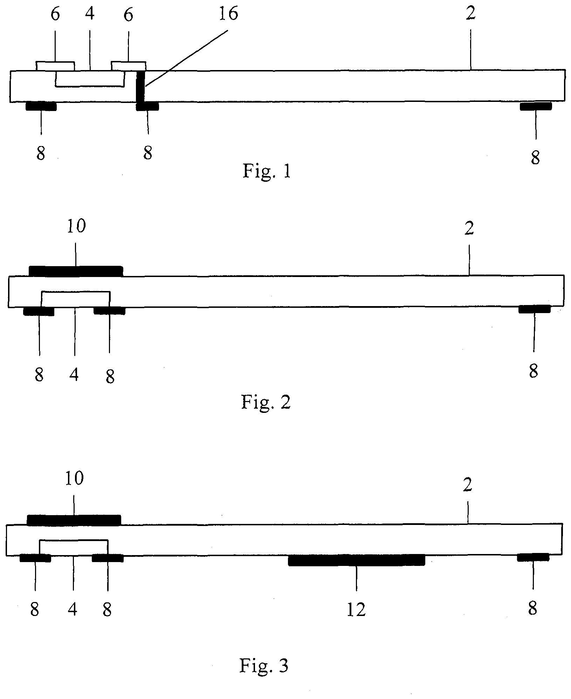

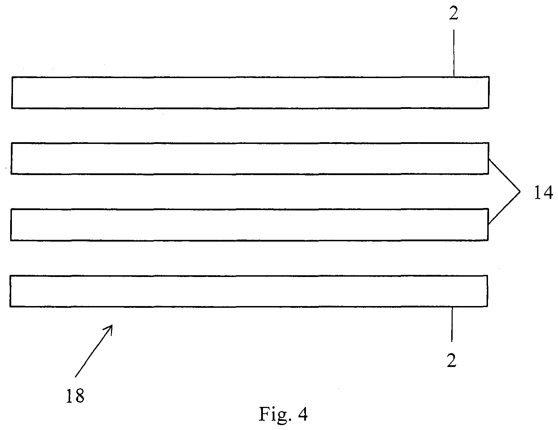

Figur 1 zeigt ein erstes Ausführungsbeispiel eines Querschnitts einer erfindungsgemäßen Folie 2, in der ein Chip 4 mit Kontaktflächen 6, einer Antennenspule 8 und einer Durchkontaktierung 16 dargestellt ist. Bei der Folie 2 handelt es sich um eine transparente Folie, in die eine Vertiefung auf der Vorderseite eingebracht ist, z.B. mittels eines Lasers, in die der Chip 4 eingesetzt und befestigt ist. Die nicht dargestellten Anschlüsse des Chips 4 sind mit den Kontaktflächen 6 verbunden. Bei den Kontaktflächen 6 handelt es sich z.B. um Kontaktflächengemäß ISO 7816. Bei dem Chip 4 handelt es sich in Figur 1 um einen Chip 4 für eine kontaktgebundene als auch für eine kontaktlose Schnittstelle. Als kontaktgebundene Schnittstelle dienen die Kontaktflächen 6 und als kontaktlose Schnittstelle die Antennenspule 8. Die Antennenspule 8 ist mittels geeigneter Durckontaktierungen 16 mit dem Chip 4 elektrisch leitend verbunden. Aus Gründen der Übersichtlichkeit wurde hier nur eine Durchkontaktierung 16 dargestellt, wobei zum Betrieb der Antennenspule 8 mindestens zwei Durchkontaktierungen 16 notwendig sind. Die Durchkontaktierung 16 wird hergestellt, indem z.B. mittels eines Lasers oder eines Wasserstrahls eine vollständige Durchdringung der Folie 2 hergestellt wird. Anschließend wird die Durchdringung mit einem leitfähigen Material ausgefüllt oder die Seitenwände der Durchdringung werden mit dem leitfähigen Material beschichtet, wobei das leitfähige Material sowohl mit einem Anschluss des Chips für eine kontaktlose Kommunikation als auch mit der Antennenspule verbunden wird. Zur Verbindung der Antennenspule 8 mit den Anschlüssen des Chips 8 werden z.B. gemäß ISO 7816 die Anschlüsse C4 und C8 verwendet. Die Antennenspule 8 wird mittels eines elektrisch leitfähigen transparenten Materials gedruckt. Dies hat den Vorteil, dass wenn die Folie 2, wie später in Figur 4 gezeigt wird, zur Herstellung eines tragbaren Datenträgers 18 als äußerste Folie 2 verwendet wird, dann ist von außen die Antennenspule 8 nicht sichtbar, weil sie aus transparenten Material besteht und stört somit nicht den optischen Eindruck einer bedruckten Inlayfolie 14. Sollte optisch eine sichtbare Antennenspule nicht stören, kann sie z.B. auch in Ätztechnologie oder einer anderen geeigneten Technologie hergestellt werden. Die Folie 2 kann sowohl mittels eines Laminationsverfahrens als auch mittels eines Klebstoffs mit einer anderen Folie dauerhaft verbunden werden. Ferner kann die Folie 2 mittels eines Rolle-zu-Rolle- oder eines Rolle-zu-Bogen-Verfahrens sowohl hergestellt als auch verarbeitet werden. Alternativ kann die Folie 2 auch als Bogen verarbeitet werden.

Figur 2 zeigt ein zweites Ausführungsbeispiel einer erfindungsgemäßen Folie 2, in der eine Abdeckung 10 auf der gegenüberliegenden Folienseite des Chips 4 angeordnet ist, damit der Chip 4 nicht von aussen zu erkennen ist. In Figur 2 ist beispielsweise der Chip 4 mit einer Antennenspule 8 als kontaktlose Schnittstelle dargestellt. Ferner ist der Chip 4 in Figur 2 auf der Rückseite der Folie 2 angeordnet. Die Rückseite der Folie 2 wird genutzt, um die Folie 2 mit einer anderen Folie zu verbinden. Damit der Chip 4 nicht von außen gesehen werden kann, wurde auf der Vorderseite der Folie 2 über dem Chip 4 eine Abdeckung 10 aufgebracht. Die Abdeckung 10 kann z.B. gedruckt werden. Alternativ kann die Abdeckung 10 ein sogenanntes Patch sein, z.B. ein aufgeklebtes Hologramm. Der Patch kann auch später auf den fertig hergestellten tragbaren Datenträger 18, wie er in Figur 4 dargestellt wird, aufgebracht werden. Dies kann beispielsweise mittels eines Hologramms im Hotstampverfahren durchgeführt werden.

Figur 3 zeigt ein drittes Ausführungsbeispiel einer erfindungsgemäßen Folie 2, bei der zusätzlich zum zweiten Ausführungsbeispiel ein zusätzliches elektronisches Bauelement 12, z.B. eine Anzeige oder ein Sensor, auf der Folie 2 angeordnet ist. Das zusätzliche elektronische Bauelement 12 kann z.B. auf die Folie 2 gedruckt werden oder als diskretes Bauelement in eine herzustellende Vertiefung in der Folie 2 eingesetzt werden. Ferner können als zusätzliche elektronische Bauelemente 12 z.B. ein Treiber-IC für die Anzeige, ein Widerstand, eine Kapazität und/oder eine Induktivität auf der Rückseite der Folie 2 angeordnet werden. Wie in Figur 4 beschrieben, kann auch über dem zusätzlichen elektronischen Bauelement 12 eine Abdeckung 10 angeordnet werden, wenn es sich nicht um ein Display oder ein anderes optisches Anzeigeelement handelt.

Figur 4 zeigt im Querschnitt den prinzipiellen Aufbau eines erfindungsgemäßen tragbaren Datenträgers 18, in den eine erfindungsgemäße Folie 2 integriert ist, wobei die Folie 2 nur prinzipiell dargestellt ist. Der in Figur 4 dargestellte Datenträger 18 besteht aus zwei erfindungsgemäßen Folien 2, welche auf den Außenseiten des Datenträgers 18 angeordnet sind, und aus zwei opaken, d.h. lichtundurchlässigen Folien 14, sogenannten Inlays. Alternativ kann der Datenträger 18 auch nur eine erfindungsgemäße Folie 2 oder mehrere opake Folien 14 umfassen. Die Folien 14 sind auf der Seite, die mit der Folie 2 verbunden wird, mit einem Motiv bedruckt, wobei das Motiv nicht dargestellt ist. Bei dem Motiv kann es sich z.B. um Zahlen, Buchstaben, Symbole, Schriftzüge, Designs, Fotos, etc. handeln, das von außen durch die Folie 2 hindurch zu erkennen ist. Neben dem in Figur 4 dargestellten Ausführungsbeispiel kann der Datenträger 18 auch mehr Folienschichten als dargestellt umfassen. Alternativ können die Folien 14 auch transparent, d.h. lichtdurchlässig sein. Ferner können beide oder nur eine Folie 2 mit elektronischen Bauelementen bestückt sein.

### Bezugszeichenliste

- 2: erfindungsgemäße transparente Folie
- 4: Chip
- 6: Kontaktflächen
- 8: Antennenspule
- 10: Abdeckung
- 12: zusätzliches elektronisches Bauelement, z.B. Display, Sensor, etc.
- 14: opake Folie, sogenanntes Inlay
- 16: Durchkontaktierung
- 18: erfindungsgemäßer tragbarer Datenträger

## Patentansprüche

1. Verfahren zur Herstellung eines tragbaren Datenträgers (18),
wobei der tragbare Datenträger (18) eine Folie (2) enthält, ein elektronisches Bauelement (4, 12) und eine Schnittstelle (6, 8),
wobei die Folie (2) als Träger mindestens eines elektronischen Bauelements (4, 12) und mindestens einer Schnittstelle (6, 8) dient, **dadurch gekennzeichnet, dass**
als Folie eine transparente Folie verwendet wird,
wobei elektrische Leiterbahnen auf der Folie (2) mittels eines transparenten, elektrisch leitfähigen Materials gedruckt werden, um das elektronische Bauelement (4, 12) mit der Schnittstelle (6, 8) elektrisch leitend zu verbinden, wobei eine Abdeckung (10) auf die dem elektronischen Bauteil (4, 12) gegenüberliegende Seite der Folie (2) aufgebracht wird, derart, dass das elektronische Bauteil (4, 12) nicht durch die transparente Folie (2) hindurch zu erkennen ist.

2. Verfahren nach Anspruch 1, **dadurch gekennzeichnet, dass** mindestens ein elektronisches Bauelement (4, 12) auf der Oberfläche der Folie (2) und/oder in einer Vertiefung der Folie (2) angeordnet wird.

3. Verfahren nach Anspruch 1 oder 2, **dadurch gekennzeichnet, dass** auf der Folie (2) eine kontaktgebundene und/oder eine kontaktlose Schnittstelle (6, 8) angeordnet wird.

4. Verfahren nach einem der Ansprüche 1 bis 3, **dadurch gekennzeichnet, dass** die kontaktlose und/oder die kontaktgebundene Schnittstelle (6, 8) mittels des transparenten, elektrisch leitfähigen Materials auf die Folie (2) gedruckt wird.

5. Verfahren nach einem der Ansprüche 1 bis 4, **dadurch gekennzeichnet, dass** die kontaktgebundene Schnittstelle (6) und die kontaktlose Schnittstelle (8) auf gegenüberliegenden Seiten der Folie (2) angeordnet werden.

6. Verfahren nach einem der Ansprüche 1 bis 5, **dadurch gekennzeichnet, dass** als kontaktgebundene Schnittstelle (6) eine Schnittstellengeometrie gemäß ISO 7816 verwendet wird.

7. Verfahren nach einem der Ansprüche 1 bis 6, **dadurch gekennzeichnet, dass** als kontaktlose Schnittstelle eine Antennenspule (8) verwendet wird.

8. Verfahren nach einem der Ansprüche 1 bis 7, **dadurch gekennzeichnet, dass** als transparentes, elektrisch leitfähiges Material Indiumzinnoxid oder Graphen verwendet wird.

9. Verfahren nach einem der Ansprüche 1 bis 8, **dadurch gekennzeichnet, dass** als Abdeckung (10) ein Hologramm auf die Folie (2) aufgebracht wird.

10. Verfahren nach einem der Ansprüche 1 bis 9, **dadurch gekennzeichnet, dass** auf mindestens einer Außenseite des Datenträgers (18) eine transparente Folie (2) angeordnet wird.

11. Verfahren nach Anspruch 10, **dadurch gekennzeichnet, dass** die transparente Folie (2) auf einem opaken oder transparenten Inlay (14) angeordnet wird.

12. Verfahren nach Anspruch 11, **dadurch gekennzeichnet, dass** auf das Inlay (14) ein Motiv gedruckt wird.

## Claims

1. A method for manufacturing a portable data carrier (18), wherein the portable data carrier (18) contains a foil (2), an electronic component (4, 12) and an interface (6, 8), wherein the foil (2) serves as a carrier of at least one electronic component (4, 12) and at least one interface (6, 8), **characterized in that** a transparent foil is used as the foil, wherein electrical conductor paths are printed on the foil (2) by means of a transparent, electrically conductive material in order to electrically conductively connect the electronic component (4, 12) to the interface (6, 8), wherein a cover (10) is applied to the side of the foil (2) opposite the electronic component (4, 12) such that the electronic component (4, 12) is not recognizable through the transparent foil (2).

2. The method according to claim 1, **characterized in that** at least one electronic component (4, 12) is arranged on the surface of the foil (2) and/or in a depression of the foil (2).

3. The method according to claim 1 or 2, **characterized in that** a contact-type and/or a contactless interface (6, 8) is arranged on the foil (2).

4. The method according to any of claims from 1 to 3, **characterized in that** the contactless and/or the contact-type interface (6, 8) is printed onto the foil (2) by means of the transparent, electrically conductive material.

5. The method according to any of claims 1 to 4, **characterized in that** the contact-type interface (6) and the contactless interface (8) are arranged on opposite sides of the foil (2).

6. The method according to any of claims 1 to 5, **characterized in that** an interface geometry according to ISO 7816 is employed as the contact-type interface (6).

7. The method according to any of claims 1 to 6, **characterized in that** an antenna coil (8) is employed as the contactless interface.

8. The method according to any of claims 1 to 7, **characterized in that** indium tin oxide or graphene is employed as the transparent, electrically conductive material.

9. The method according to any of claims 1 to 8, **characterized in that** a hologram is applied to the foil (2) as a cover (10).

10. The method according to any of claims 1 to 9, **characterized in that** a transparent foil (2) is arranged on at least one outer side of the data carrier (18).

11. The method according to claim 10, **characterized in that** the transparent foil (2) is arranged on an opaque or transparent inlay (14).

12. The method according to claim 11, **characterized in that** a motif is printed on the inlay (14).

## Revendications

1. Procédé de fabrication d'un support de données (18) portable,
cependant que le support de données (18) portable comporte une feuille (2), un composant électronique (4, 12) et une interface (6, 8),
cependant que la feuille (2) sert de support d'au moins un composant électronique (4, 12) et d'au moins une interface (6, 8), **caractérisé en ce que**
en tant que feuille, une feuille transparente est utilisée,
cependant que des pistes conductrices électriques sont imprimées sur la feuille (2) au moyen d'un matériau transparent électriquement conducteur afin de relier le composant électronique (4, 12) de façon électriquement conductrice à l'interface (6, 8), cependant qu'un recouvrement (10) est placé sur la face, de la feuille (2), opposée au composant électronique (4, 12), de telle façon que le composant électronique (4, 12) n'est pas reconnaissable à travers la feuille (2) transparente.

2. Procédé selon la revendication 1, **caractérisé en ce qu'**au moins un composant électronique (4, 12) est agencé sur la surface de la feuille (2) et/ou dans un renfoncement de la feuille (2).

3. Procédé selon la revendication 1 ou 2, **caractérisé en ce que**, sur la feuille (2), une interface (6, 8) avec contact et/ou une sans contact est agencée.

4. Procédé selon une des revendications de 1 à 3, **caractérisé en ce que** l'interface (6, 8) avec contact et/ou sans contact est imprimée sur la feuille (2) au moyen du matériau transparent électriquement conducteur.

5. Procédé selon une des revendications de 1 à 4, **caractérisé en ce que** l'interface avec contact (6) et l'interface sans contact (8) sont agencées sur des faces opposées de la feuille (2).

6. Procédé selon une des revendications de 1 à 5, **caractérisé en ce que**, en tant qu'interface avec contact (6), une géométrie d'interface suivant ISO 7816 est utilisée.

7. Procédé selon une des revendications de 1 à 6, **caractérisé en ce que**, en tant qu'interface sans contact, une bobine d'antenne (8) est utilisée.

8. Procédé selon une des revendications de 1 à 7, **caractérisé en ce que**, en tant que matériau transparent électriquement conducteur, de l'oxyde d'indium-étain ou du graphène est utilisé.

9. Procédé selon une des revendications de 1 à 8, **caractérisé en ce que**, en tant que recouvrement (10), un hologramme est appliqué sur la feuille (2).

10. Procédé selon une des revendications de 1 à 9, **caractérisé en ce que**, sur au moins une face extérieure du support de données (18), une feuille (2) transparente est agencée.

11. Procédé selon la revendication 10, **caractérisé en ce que** la feuille (2) transparente est agencée dans un inlay (14) opaque ou transparent.

12. Procédé selon la revendication 11, **caractérisé en ce que**, sur l'inlay (14), un motif est imprimé.
